# EUROPÄISCHE PATENTSCHRIFT

(11) **EP 3 772 247 B1**
(45) Veröffentlichungstag und Bekanntmachung des Hinweises auf die Patenterteilung: **21.06.2023**
(21) Anmeldenummer: 20188845.0
(22) Anmeldetag: 31.07.2020
(51) Int. Cl.: H05K 13/02, H05K 13/00

(54) **SUBSTRATMAGAZIN, SUBSTRATMAGAZINSYSTEM UND SUBSTRATBESTÜCKUNGSANLAGE**
SUBSTRATE CARTRIDGE, SUBSTRATE CARTRIDGE SYSTEM, AND SUBSTRATE FITTING SYSTEM
CHARGEUR DE SUBSTRAT, SYSTÈME DE CHARGEUR DE SUBSTRAT ET INSTALLATION D'IMPLANTATION DE SUBSTRAT

(30) Priorität: 01.08.2019 DE 102019211603
(43) Veröffentlichungstag der Anmeldung: 03.02.2021
(73) Patentinhaber: ASYS Automatisierungssysteme GmbH, 89160 Dornstadt (DE)
(72) Erfinder: Mang, Klaus, 89143 Blaubeuren (DE); Lehner, Jürgen, 89150 Laichingen (DE)
(74) Vertreter: Clarenbach, Carl-Philipp

(56) Entgegenhaltungen:
- EP-A2- 0 123 167
- DE-A1- 19 919 188
- DE-U1-202020 103 705
- JP-A- 2002 110 776
- JP-A- 2008 137 673

## Beschreibung

Die Erfindung betrifft ein Substratmagazin für eine Substratbestückungsanlage, mit einem Rahmen, in welchem mehrere Schubfächer zur Aufnahme von zumindest jeweils einem flächigen Substrat, insbesondere Leiterplatte Wafer, Solarzelle oder Träger, beispielsweise aus Kunststoff oder Keramik gefertigt, übereinanderliegend angeordnet sind, wobei jedes Schubfach durch zwei parallel und beabstandet zueinander auf derselben Höhe des Rahmens angeordnete Führungsschienen mit jeweils einer Schiebefläche, auf welcher ein Substrat randseitig aufliegend verschiebbar ist, gebildet ist.

Weiterhin betrifft die Erfindung ein Substratmagazinsystem und eine Substratbestückungsanlage mit zumindest einem Substratmagazin, das wie vorstehend beschrieben ausgebildet ist.

Substratmagazine der eingangs genannten Art sind aus dem Stand der Technik bereits bekannt. In Substratbestückungsanlagen oder Fertigungslinien für Leiterplatten werden in der Regel Leiterplatten oder Leiterplattenrohlinge aus einem Magazin entnommen und nach einem erfolgten Bestücken der Leiterplatten mit elektrischen und/oder elektronischen Bauteilen in das eine oder in ein anderes Magazin eingelagert. Häufig erfolgt dies mithilfe einer automatischen Be- und Entladevorrichtung für Leiterplattenmagazine. Herkömmliche Magazine haben häufig bis zu 50 Schubfächer, die übereinanderliegend angeordnet sind, und in denen jeweils eine einzelne Leiterplatte lagerbar ist. Das Schubfach wird dabei in der Regel durch zwei seitliche Führungsschienen gebildet, die jeweils eine Schiebefläche für die Leiterplatte aufweisen, auf welcher die jeweilige Leiterplatte randseitig aufliegt. Durch die randseitige Auflage wird gewährleistet, dass der mit gegebenenfalls bereits bestückten Bauteilen versehene mittlere Abschnitt der Leiterplatte frei von einem Berührungskontakt zu dem Magazin ist, sodass bereits bestückte Bauteile durch eine Berührung nicht beschädigt werden. Die Führungsschienen sind dabei auf derselben Höhe des Rahmens beabstandet zueinander angeordnet. Bei ausreichender Länge der Führungsschienen und Kürze der Leiterplatten ist es außerdem möglich, mehrere Leiterplatten in ein Schubfach hintereinander zu schieben. Dabei liegen die Leiterplatten entweder auf Stoß oder beabstandet in Schieberichtung zueinander. Beim Transport des Magazins von der Substratbestückungsanlage zu beispielsweise einer Montageanlage, durch welche die Leiterplatten beziehungsweise Substrate aus dem Substratmagazin entnommen und ihrem Bestimmungszweck zugeführt werden, können die Leiterplatten oder Substrate in dem Substratmagazin verrutschen und im schlimmsten Fall übereinander geschoben werden. Dadurch können zum einen Komponenten der jeweiligen Leiterplatte beschädigt und zum anderen die korrekte Entnahme der Substrate aus dem Substratmagazin erschwert werden.

Aus der Offenlegungsschrift EP 0 123 167 A2 ist ein Substratmagazin bekannt, bei dem mehrere Werkstücke durch Abstandshalter voneinander getrennt und hintereinander in Führungsnuten angeordnet sind, wobei die Abstandshalter durch Vorsprünge in Auflageflächen der Führungsnuten gebildet sind, und wobei die Werkstücke in den Führungsnuten durch Anheben über die Vorsprünge hinweg verschiebbar sind.

Die Offenlegungsschrift JP 2008 137673 A offenbart ein weiteres Substratmagazin, bei dem Substrate durch elastische Gummikörper an ihrem Platz gehalten werden, indem jeweils eine Luftkammer zwischen einem der Gummikörper und einer Führungsschiene aufgeblasen wird, sodass die Gummikörper von oben und von unten an die Substrate angepresst werden.

Der Erfindung liegt die Aufgabe zugrunde, ein verbessertes Substratmagazin zu schaffen, das einen sicheren Transport des Substratmagazins, insbesondere auch von mehreren Substraten in einem Schubfach erlaubt.

Die der Erfindung zugrundeliegende Aufgabe wird durch ein Substratmagazin mit den Merkmalen des Anspruchs 1 gelöst. Dieses hat den Vorteil, dass das jeweilige Substrat in einem Schubfach sicher mechanisch gehalten ist, sodass auch bei einer Bewegung des Substratmagazins von einem Ort zu einem anderen die Substrate fest oder zumindest ausreichend fest in dem jeweiligen Schubfach gehalten sind, sodass insbesondere ein Übereinanderschieben benachbarter Substrate in einem Schubfach sicher verhindert ist. Durch die erfindungsgemäße Lösung wird die oben genannte Aufgabe in kostengünstiger und auch konstruktiv einfacher Art und Weise gelöst, wobei die Lösung dauerhaft von Bestand ist und einfach gewartet oder bei Bedarf repartiert werden kann. Das erfindungsgemäße Substratmagazin sieht vor, dass jedem Schubfach zumindest ein elastisch verlagerbares Rastelement zugeordnet ist, das in einem ersten, unbelasteten Zustand, sich zumindest bereichsweise über die Schiebefläche einer der Führungsschienen des Schubfachs erstreckt, und in einem zweiten elastisch verformten Zustand die Schiebefläche freigibt. Zumindest einer Führungsschiene eines Schubfachs ist somit ein Rastelement zugeordnet, das elastisch verlagerbar ist, sodass es in einem entspannten Zustand eine der Schiebefläche zugeordnete Sperrung bewirkt, die durch die elastische Verformung des Rastelements aufgehoben werden kann. Wird nun ein Substrat entlang der Führungsschiene geschoben, so stößt es gegen das Rastelement in dem ersten Zustand. Durch Überwinden der Federkraft des Rastelements wird dieses zurückgeschoben, sodass das Substrat durch die Freigabe der Schiebefläche an dem Rastelement vorbeischiebbar ist. Je nach Anordnung des Rastelements entlang der Schiebefläche versperrt das Rastelement im unbelasteten Zustand dann den Schiebeweg in Einschubrichtung und/oder entgegen der Einschubrichtung. Ist das Rastelement nahe zu der Einschubseite der Schiebefläche beziehungsweise des Schubfachs angeordnet, so verhindert es ein ungewolltes Herausschieben des Rastelements entgegen der Einschubrichtung. Ist das Rastelement hingegen beispielsweise auf einer von der Einschubseite abgewandten Ausschubseite angeordnet, so verhindert das Rastelement, dass das Substrat über die Schiebefläche hinaus aus dem Magazin wieder ungewollt herausrutscht. Ist das Rastelement beispielsweise mittig auf der Führungsschiebe bezogen auf ihre Längserstreckung in Schieberichtung angeordnet, so wirkt es beispielsweise mit einer Randseite des Substrats, bevorzugt mit einer seitlichen Vertiefung in der Randseite des Substrats zusammen, um dieses in einer sicheren Position im unbelasteten Zustand kraftschlüssig oder formschlüssig in beide Schieberichtungen auf der Schiebefläche zu halten, oder es dient als Trennelement zwischen zwei Substraten, die sich auf der Schiebefläche befinden, wobei dann das Rastelement zwischen den beiden Substraten liegt und dadurch insbesondere ein Übereinanderschieben der Substrate bei einem Transport des Magazins verhindert. Das Substratmagazin ist bevorzugt entweder derart ausgebildet, dass es nur von einer Seite be- und entladbar ist, sodass die Einschubseite gleichzeitig auch die Ausschubseite des jeweiligen Schubfachs darstellt, oder derart, dass das Substratmagazin von zwei Seiten mit Substraten beladen oder von diesen befreit werden kann, wobei dann das Substratmagazin bevorzugt an zwei gegenüberliegenden Seiten des Rahmens die Einschubseite und die Ausschubseite des jeweiligen Schubfachs aufweist, sodass ein Substrat auch vollständig durch den Rahmen hindurch geschoben werden kann. Bevorzugt ist zumindest eine der Seitenwände des Rahmens derart verschiebbar gelagert, dass die lichte Weite zwischen den beiden die Führungsschienen tragenden Seitenwänden und damit der Abstand von auf gleicher Höhe liegenden Führungsschienen zueinander veränderbar ist, sodass die Breite beziehungsweise lichte Weite des Substratmagazins an die Breite der verwendeten Substrate anpassbar ist. Optional ist ein Antrieb für die Verschiebung manuell, motorisch, insbesondere elektromotorisch, hydraulisch oder pneumatisch ausgebildet.

Erfindungsgemäß ist vorgesehen, dass das Rastelement als elastisch verformbare Klemmfeder ausgebildet ist, die einendig an dem Rahmen und/oder der Führungsschiene befestigt und anderendig mit einem verlagerbaren Klemmende der Schiebefläche zugeordnet ist. Das Rastelement stellt somit selbst die Rückstellkraft zur Verfügung, welche das Rastelement in den ersten Zustand drängt. Durch die Ausbildung als Klemmfeder wird eine kompakte Ausführungsform des Substratmagazins geboten, die nur wenige Einzelteile für das sichere Halten von Substraten in zumindest einem Schubfach gewährleistet. Dadurch, dass das Rastelement beziehungsweise die Klemmfeder einendig an dem Rahmen und/oder der Führungsschiene befestigt und anderendig der Schiebefläche zugeordnet ist, ist das Rastelement in der Art einer Federzunge ausgebildet, die ein freies Klemmende aufweist. Dadurch ist eine einfache Verformbarkeit entgegen der Federkraft des Rastelements beim Verschieben der Substrate gewährleistet, sodass die Verrastung durch eine entsprechende Kraftbeaufschlagung des jeweiligen Substrats einfach überwunden werden kann, wobei gleichzeitig ein ungewolltes Verschieben der Substrate sicher verhindert ist.

Weiterhin ist bevorzugt vorgesehen, dass die Klemmfeder zur Ausbildung des Klemmendes einen v-förmigen beziehungsweise dachförmigen Verlauf aufweist. Durch den v-förmigen Verlauf wird zum einen die Stabilität des Klemmendes erhöht und zum anderen gewährleistet der Verlauf, dass das Klemmende unabhängig von der Schieberichtung des Substrats in den zweiten Zustand verformt beziehungsweise verlagert werden kann.

Vorzugsweise verläuft dazu die Klemmfeder derart dachförmig in dem Klemmende, dass das Klemmende im Bereich der Schiebefläche der zugeordneten Führungsschiene eine Anlaufschräge in jeder Schieberichtung eines Substrats entlang der Führungsschiene aufweist. Dadurch ist gewährleistet, dass unabhängig davon, in welche der Richtung das Substrat geschoben wird und gegen die Klemmfeder trifft, diese durch das Verschieben des Substrats unter Überwindung ihrer Federkraft in den zweiten Zustand überführbar ist.

Besonders bevorzugt weist die Klemmfeder einen rechteckförmigen Querschnitt auf, der eine Höhe und eine Breite aufweist, wobei die Breite im Vergleich zur Höhe viel kleiner ist. Die Klemmfeder ist somit in der Art einer Blattfeder ausgebildet, welche ein geringes Gewicht aufweist und in vorteilhafter Weise die oben genannte Funktion durch eine elastische Verformbarkeit erfüllt.

Gemäß einer bevorzugten Weiterbildung der Erfindung ist die Klemmfeder mit ihrer Höhe senkrecht zur Ebene der Schiebefläche ausgerichtet. Dadurch ist die Klemmfeder schmal bauend an dem Substratmagazin angeordnet und ist parallel zur Ebene der Schiebefläche verlagerbar, sodass die Klemmfeder seitlich mit dem jeweiligen Substrat zusammenwirkt. Dadurch ist eine einfache und bauraumsparende Anordnung der Klemmfeder geboten.

Gemäß einer alternativen Ausführungsform der Erfindung ist vorgesehen, dass die Klemmfeder bevorzugt mit ihrer Höhe parallel zur Ebene der Schiebefläche ausgerichtet ist. Dadurch ist die Klemmfeder, insbesondere die Blattfeder, parallel zur Schiebefläche ausgerichtet, sodass sie durch die elastische Verformung senkrecht zur Schiebefläche verlagerbar ist und damit mit einer Unterseite oder Oberseite des jeweiligen Substrats an dessen Randbereich beziehungsweise Seitenrand zusammenwirkt. Auch hierdurch wird eine Arretierung des Substrats in dem jeweiligen Schubfach sicher gewährleistet, die vom Benutzer bei Bedarf aufgehoben werden kann.

Erfindungsgemäß weist der Rahmen und/oder die jeweilige Führungsschiene für jede Klemmfeder jeweils eine Aussparung auf, durch welche sich zumindest das Klemmende der zugeordneten Klemmfeder im ersten Zustand der Feder hindurch zu der Schiebefläche erstreckt. Durch die Aussparung ist somit gewährleistet, dass das Klemmende im ersten Zustand im Bereich der Schiebefläche liegt. Durch einen ansonsten geschlossenen Rahmen und/oder Führungsschiene ist gewährleistet, dass beispielsweise der Befestigungsbereich der Klemmfeder sicher vor äußeren Einflüssen geschützt ist, und dass das Eintreten von Schmutzpartikeln in das Magazin selbst erschwert wird.

Weiterhin ist bevorzugt vorgesehen, dass die jeweilige Klemmfeder durch eine Verschraubung, Vernietung, Verrastung oder Klemmung an dem Rahmen und/oder der Führungsschiene befestigt ist. Durch die Verschraubung, Vernietung, Verrastung und/oder Verklemmung ist eine einfache Fixierung der Klemmfeder an dem Rahmen und/oder der Führungsschiene mit kostengünstigen Mitteln gewährleistet. Die Befestigung kann dabei bei Bedarf, zumindest im Fall der Verschraubung, Verrastung und/oder Verklemmung, auch zerstörungsfrei aufgelöst werden, um beispielswiese die Klemmfeder zu Wartungszwecken auszutauschen oder herauszunehmen.

Gemäß einer weiteren Ausführungsform der Erfindung ist die jeweilige Klemmfeder bevorzugt einendig mit dem Rahmen und/oder der Führungsschiene verschweißt, verlötet und/oder verklebt. Dadurch ist eine dauerhafte Verbindung der Klemmfeder mit dem jeweiligen Rahmen oder der jeweiligen Führungsschiene gewährleistet, die besonders haltbar und robust gestaltet ist. Durch einen automatisierten Schweiß- oder Lötvorgang ist außerdem eine zeitnahe Herstellung des Substratmagazins mit einer oder einer Vielzahl von Klemmfedern gewährleistet.

Weiterhin ist bevorzugt vorgesehen, dass zumindest einer Führungsschiene zwei Klemmfedern zugeordnet sind, die in Schieberichtung der Führungsschiene beabstandet zueinander angeordnet sind. So kann beispielsweise eine Klemmfeder dem Einschubende und eine andere oder weitere Klemmfeder dem Ausschubende zugeordnet sein. Optional sind die Klemmfedern zwischen Einschubseite und Ausschubseite an der Führungsschiene angeordnet, sodass beispielsweise zwischen Einschubseite und einer Klemmfeder ein Substrat, zwischen Ausschubseite und der weiteren Klemmfeder ein weiteres Substrat und zwischen den beiden Klemmfedern ein drittes Substrat haltbar beziehungsweise anordenbar ist. Alternativ, je nach Ausgestaltung der Substrate, können auch zwei Substrate in dem Schubfach gehalten sein, die dann jeweils seitlich eine Aussparung aufweisen, welche mit jeweils einer der Klemmfedern zusammenwirkt.

Weiterhin ist bevorzugt vorgesehen, dass jedem Schubfach eine oder mehrere Klemmfedern nur einer Führungsschiene des Schubfachs zugeordnet sind. Dadurch weist das jeweilige Schubfach einseitig zumindest eine Klemmfeder auf, welche zur Arretierung des einen oder der mehreren Substrate in dem Schubfach dient. Dadurch ist eine kostengünstige und dennoch verlässliche Lösung geboten.

Alternativ sind bevorzugt jedem Schubfach eine oder mehrere Klemmfedern jeweils einer der Führungsschienen des Schubfachs zugeordnet. Damit befindet sich zumindest eine Klemmfeder an jeder Führungsschiene des Schubfachs, sodass das Substrat beim Einschieben oder Ausschieben mit jeweils mindestens zwei Klemmfedern zusammenwirkt, und deren Federkraft gleichzeitig oder nacheinander überwinden muss, um ein Weiterschieben zu ermöglichen. Dadurch ist eine gleichmäßige Belastung der Substrate beim Verschieben gewährleistet, die verhindert, dass beispielsweise ein Substrat in dem Schubfach verkantet.

Das erfindungsgemäße Substratmagazinsystem mit den Merkmalen des Anspruchs 15 zeichnet sich dadurch aus, dass eine Vielzahl von gleichförmigen Substraten vorhanden sind, wobei der horizontale Abstand der Führungsschienen eines Schubfachs zueinander derart gewählt ist, dass jedes der Substrate beidseitig mit jeweils einem Randabschnitt auf den Führungsschienen aufliegen kann. Die Substrate sind dabei gleichförmig ausgebildet, sodass jedes Substrat des Systems in dem Substratmagazin sicher aufnehmbar ist, sodass es mit seinen beiden Randabschnitten auf den Führungsschienen eines Schubfachs auflegbar und verschiebbar ist. Durch die erfindungsgemäße Ausbildung des Substratmagazins ergibt sich, dass die Substrate darüber hinaus sicher in dem jeweiligen Schubfach oder in zumindest einem der Schubfächer lösbar arretiert gehalten werden können oder sind. Es ergeben sich insbesondere die zuvor bereits genannten Vorteile. Weitere Vorteile und bevorzugte Merkmale und Merkmalskombinationen ergeben sich insbesondere aus dem zuvor Beschriebenen sowie aus den Ansprüchen. Vorzugsweise handelt es sich bei den Substraten um Leiterplatten, Wafer, Solarzellen oder Träger, die beispielsweise aus Keramik oder Kunststoff gefertigt sind. Durch die optionale Ausbildung des Substratmagazins derart, dass zumindest eine der Seitenwände mit den daran befindlichen Führungsschiene oder Führungsschienen verlagerbar ist, um die lichte Weite zwischen den Führungsschienen beziehungsweise Seitenwänden zu variieren, können auch Substrate unterschiedlicher Breite in dem Substratmagazinsystem eingesetzt werden.

Gemäß einer bevorzugten Weiterbildung des Substratmagazins ist vorgesehen, dass die zumindest eine Klemmfeder derart mittig an der Führungsschiene angeordnet ist, dass zwischen der Klemmfeder und der Einschubseite sowie zwischen Klemmfeder und der Ausschubseite jeweils ein Substrat anordenbar ist. Sind der Führungsschiene zwei Klemmfedern zugeordnet, so sind diese bevorzugt derart weit voneinander beabstandet, dass zwischen den Klemmfedern ein weiteres Substrat aufnehmbar ist. Dabei ist die eine Klemmfeder bevorzugt derart weit von der Einschubseite und die andere Klemmfeder bevorzugt derart weit von der Ausschubseite der jeweiligen Führungsschiene angeordnet, dass insgesamt drei Substrate in dem Schubfach aufnehmbar und durch die Klemmfedern arretierbar sind.

Gemäß einer bevorzugten Weiterbildung der Erfindung weist jedes Substrat zumindest eine seitliche Einkerbung an zumindest einem der Randabschnitte auf, wobei die Einkerbung zur Aufnahme des Klemmendes einer der Klemmfedern ausgebildet ist. Dadurch wirkt die Klemmfeder direkt mit dem jeweiligen Substrat zusammen und arretiert das Substrat einfach in beide Schieberichtungen. Wobei durch die bevorzugte Ausbildung des Klemmendes mit einem dachförmigen oder v-förmigen Verlauf gewährleistet ist, dass das Substrat in beide Schieberichtungen aus dem Schubfach herausgenommen werden kann, unter Überwindung der Federkraft des Klemmelements.

Die erfindungsgemäße Substratbestückungsanlage mit den Merkmalen des Anspruchs 18 zeichnet sich durch das erfindungsgemäße Substratmagazin oder Substratmagazinsystem aus. Es ergeben sich dadurch die bereits genannten Vorteile. Weitere Vorteile und bevorzugte Merkmale und Merkmalskombinationen ergeben sich insbesondere aus dem zuvor Beschriebenen sowie aus den Ansprüchen.

Im Folgenden soll die Erfindung anhand der Zeichnung näher erläutert werden. Dazu zeigen
- Figur 1: eine Substratbestückungsanlage in einer vereinfachten Darstellung,
- Figur 2: ein Substratmagazin der Substratdruckanlage in einer ersten perspektivischen Darstellung,
- Figuren 3A und 3B: zwei Ausführungsbeispiele eines Rastelements des Substratmagazins,
- Figur 4: eine vereinfachte Draufsicht auf ein Schubfach des Substratmagazins gemäß einem ersten Ausführungsbeispiel und
- Figur 5: eine vereinfachte Draufsicht auf ein Schubfach des Substratmagazins gemäß einem zweiten Ausführungsbeispiel

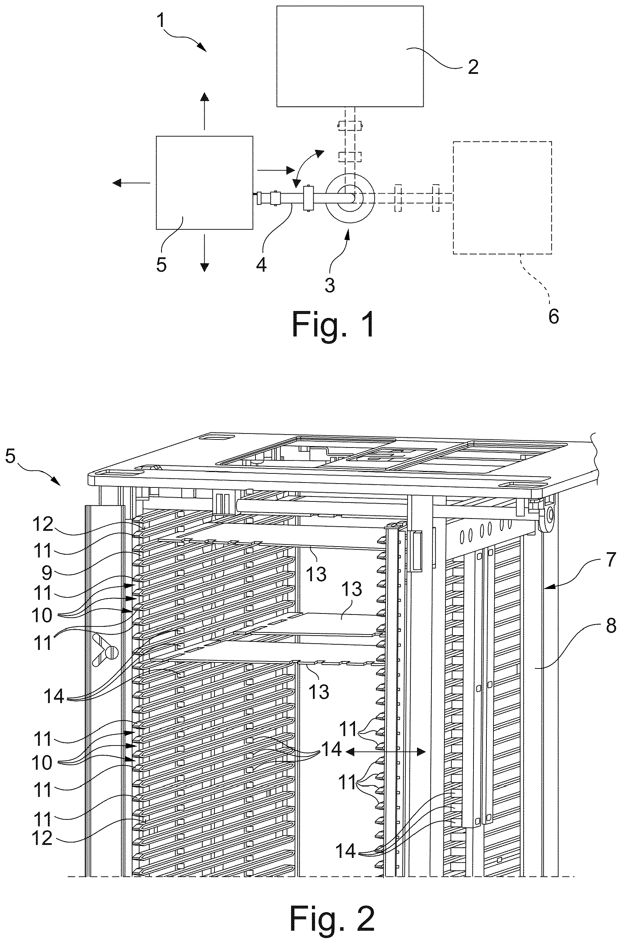

Figur 1 zeigt in einer vereinfachten perspektivischen Draufsicht eine Substratbestückungsanlage 1, die eine Substratbestückungseinrichtung 2 aufweist, mittels welcher Substrate, insbesondere Leiterplatten, Wafer, Solarzellen, Träger, insbesondere Trägerplatten oder Trägerwannen, oder dergleichen, mit gleichen oder unterschiedlichen, insbesondere elektrischen/elektronischen Bauteilen automatisiert bestückbar sind. Die Substratbestückungsanlage 1 weist weiterhin eine Einrichtung 3 zum Zuführen und Abführen von zu bestückenden Substraten zu der Bestückungsvorrichtung 2 auf, wobei die Einrichtung 3 vorliegend als Roboterarm 4 ausgebildet ist. Die Substratbestückungsanlage 1 weist weiterhin ein Magazin 5 auf, das zur Aufnahme der zu bestückenden Substrate ausgebildet ist. Das Substratmagazin 5 dient zur Bereitstellung und/oder zur Aufnahme der zu bestückenden beziehungsweise bestückten Substrate. Optional weist die Bestückungsanlage 1 ein weiteres Substratmagazin 6 auf, sodass beispielsweise aus dem Substratmagazin 5 zu bestückende Substrate entnommen, der Bestückungseinrichtung 2 zugeführt und nach erfolgtem Bestückungsvorgang in dem weiteren Magazin 6 abgelegt werden.

Figur 2 zeigt eine vorteilhafte perspektivische Darstellung des Substratmagazins 5. Das Substratmagazin 5 weist einen Rahmen 7 auf, der zwei parallel zueinander ausgerichtete und beabstandet zueinander angeordnete Seitenwände 8, 9 sowie ein Bodenteil und ein Deckenteil, das die Seitenwände 8, 9 miteinander verbindet, auf. Das Substratmagazin 5 weist eine Vielzahl von Schubfächern 10 auf, die übereinander liegen und parallel zueinander ausgerichtet sind, sodass in jedem Schubfach 10 wenigstens ein Substrat anordenbar ist, und mehrere Substrate übereinanderliegend in dem Substratmagazin 5 gehalten werden können. Die Schubfächer 10 werden dabei durch an den Seitenwänden 8, 9 angeordnete Führungsschienen 11 gebildet, die sich entlang der jeweiligen Seitenwand 8, 9 erstrecken. Dabei sind jeweils zwei Führungsschienen 11 an den Seitenwänden 8, 9 auf gleicher Höhe des Rahmens 7 und auf den einander zugewandten Seitenflächen der Seitenwände 8, 9 angeordnet. Jede der Führungsschienen 11 weist eine Schiebefläche 12 auf, auf welcher ein Substrat randseitig auflegbar und verschiebbar ist. In Figur 2 sind beispielhaft mehrere Substrate 13 gezeigt, deren Breite B geringfügig kleiner ist als der Abstand der Seitenwände 8, 9 zueinander, sodass die Substrate mit ihrem der jeweiligen Seitenwand 8, 9 zugeordneten Randabschnitt flächig auf jeweils einer Schiebefläche 12 einer Führungsschiene 11 aufliegen. Dadurch sind die Substrate 13 entlang der Führungsflächen in dem Magazin 5 verschiebbar gelagert. Je nach Länge L der Substrate 13 können in einem Schubfach 10 dadurch ein oder mehrere Substrate 13 nebeneinander beziehungsweise hintereinander liegend angeordnet werden. Zumindest eine der Seitenwände, vorliegend die Seitenwand 8, ist derart verlagerbar in dem Rahmen 7 angeordnet, dass der Abstand zwischen den Seitenwänden 8, 9 veränderbar ist, wie durch einen Doppelpfeil in Figur 2 angezeigt. Dadurch ist die Substratmagazinbreite an die Breite der verwendeten beziehungsweise einzusetzenden Substrate 13 anpassbar.

Jeder Führungsschiene 11 sind gemäß dem vorliegenden Ausführungsbeispiel mehrere elastisch verlagerbare Rastelemente 14 zugeordnet, die in einem ersten, unbelasteten Zustand sich zumindest bereichsweise über die jeweilige Schiebefläche 12 erstrecken, und in einem zweiten elastisch verformten Zustand die jeweilige Schiebefläche 12 freigeben.

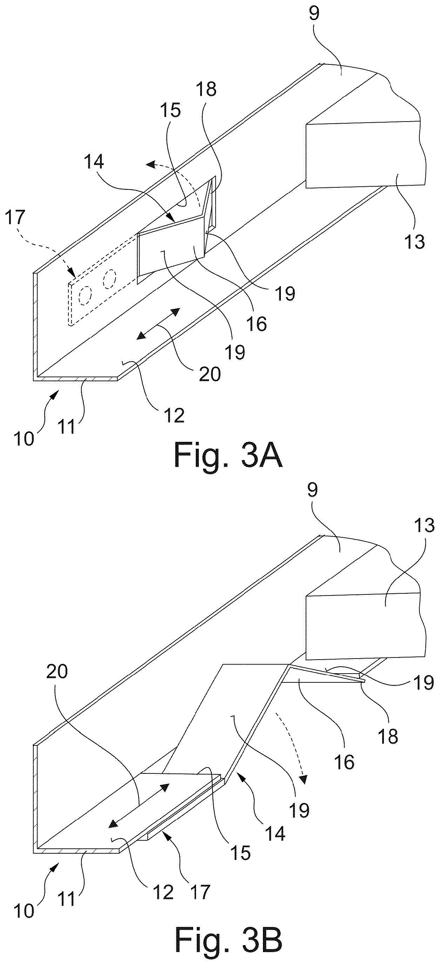

Figuren 3A und 3B zeigen in einer vereinfachten Detailansicht unterschiedliche Ausführungsbeispiele der Rastelemente 14. Figur 3A zeigt dazu eine perspektivische Darstellung eines Teils des Rahmens 7 mit Blick auf eine Führungsschiene 11 an der Seitenwand 9 des Rahmens 7, stellvertretend für alle Führungsschienen 11 des Substratmagazins 5. Die Schiebefläche 12 der Führungsschiene 11 ist dabei zumindest im Wesentlichen senkrecht zur Ebene der Seitenwand 9 ausgerichtet. Oberhalb der Schiebefläche 12 ist in der Seitenwand 9 eine Aussparung 15 ausgebildet, durch welche das Rastelement 14 sich bereichsweise hindurch erstreckt, sodass es die Schiebefläche 12 in Schieberichtung versperrt, wie in Figur 3A gezeigt. Das Rastelement 14 ist als elastisch verformbare Klemmfeder 16 ausgebildet, die blattfederförmig ausgebildet ist. Dazu weist die Klemmfeder einen Querschnitt auf, mit einer Höhe H und einer Breite B, wobei die Höhe H sehr viel größer als die Breite B ist. Die Höhe ist dabei senkrecht zur Schiebefläche 12 ausgerichtet, sodass die Blattfeder im Wesentlichen senkrecht zur Schiebefläche 12 und damit parallel zur Seitenwand 9 ausgerichtet ist. An einem ersten Ende 17 ist die Klemmfeder 16 an der Seitenwand 9 des Rahmens 7 befestigt. Beispielsweise ist dazu die Klemmfeder 16 an dem Rahmen 9 insbesondere an dem Ende 17 verschweißt, verlötet, verschraubt oder verklemmt. Durch eine bevorzugte lösbare Befestigung ist ein einfacher Austausch der Klemmfedern 16 zu Wartungszwecken möglich. An ihrem zweiten von dem Ende 17 abgewandten Ende bildet die Klemmfeder 16 ein Klemmende 18, das einen dachförmigen oder V-förmigen Verlauf in Längserstreckung der Klemmfeder 16 aufweist. Mit diesem Klemmende 18 ragt das Rastelement 14 oberhalb der Schiebefläche 12 von der Seitenwand 9 vor, sodass es die Schiebefläche 12 zumindest bereichsweise überdeckt. Gemäß dem vorliegenden Ausführungsbeispiel ist dabei das erste Ende 17 auf der von der Führungsschiene 11 abgewandten Seite der Seitenwand 9 angeordnet, sodass das Klemmende 18 durch die Aussparung 15 der Seitenwand 9 hindurchgeführt ist. Alternativ ist die Klemmfeder 16 insgesamt auf der der Führungsschiene 11 zugewandten Seite der Seitenwand 9 angeordnet.

Durch die elastisch verformbare Ausbildung der Klemmfeder 16 ist das Klemmende 18 unter elastischer Verformung der Klemmfeder 16 in Richtung der Seitenwand 9 verlagerbar, bis es die Schiebefläche 12 vollständig oder zumindest derart weit freigibt, dass ein Substrat an dem Klemmende 18 vorbeischiebbar ist. Durch den dachförmigen oder v-förmigen Verlauf des Klemmendes 18 bildet dieses zwei Anlaufschrägen 19, die mit einem auf der Führungsschiene 11 aufliegenden Substrat zusammenwirken, wenn das Substrat in die eine oder in die andere Schieberichtung entlang der Führungsschiene, wie durch einen Pfeil 20 in Figur 2A angedeutet, verschoben wird. Durch das v-förmige Klemmende 18 ist also gewährleistet, dass unabhängig von der Schieberichtung des Substrats 13 auf der Führungsschiene 11 das Klemmende 18 durch das Substrat 13 in den zweiten Zustand verlagerbar ist, sodass das Substrat 13 an der Klemmfeder 16 vorbeischiebbar ist. Die Klemmfeder 16 ist jedoch erst in den zweiten Zustand überführbar, wenn eine ausreichend hohe Druckkraft auf das Klemmende 18 durch das Substrat 13 ausgeübt wird. Dadurch wird gewährleistet, dass ein versehentliches Verschieben oder ungewolltes Verschieben des Substrats 13 auf der jeweiligen Führungsschiene 11 durch die Klemmfeder 16 sicher verhindert ist. Insbesondere wird dadurch verhindert, dass das Substrat 13 bei einem Transport des Magazins in dem Schubfach 10 verschoben wird. Insbesondere wird durch die Klemmfeder 16 verhindert, dass in Schieberichtung hintereinander in dem Schubfach 10 liegende Substrate 13 ungewollt übereinander geschoben werden können. Dadurch ist ein sicherer Transport einer Vielzahl von Substraten 13 in dem Substratmagazin 5 sicher gewährleistet.

Figur 3B zeigt ein alternatives Ausführungsbeispiel für das Rastelement 14, das sich von dem vorhergehenden Ausführungsbeispiel dadurch unterscheidet, dass die Klemmfeder 16 nicht seitlich an der Seitenwand 9, sondern direkt an der Führungsschiene 11 angeordnet und mit ihrer Höhe parallel zur Ebene der Schiebefläche 12 ausgerichtet ist. Entsprechend ist die Öffnung 15 in diesem Fall nicht in der Seitenwand 9, sondern in der Führungsschiene 11 ausgebildet, sodass das Klemmende 18 von unten über die Schiebefläche 12 vorsteht und dadurch im Bewegungsweg eines Substrats entlang der Schiebefläche 12 liegt. Wird die Federkraft der Klemmfedern 16 überwunden, so wird das Klemmende 18 nach unten gedrängt, wie durch einen Pfeil in Figur 3B angezeigt, und dadurch der Schiebeweg entlang der Führungsfläche 12 freigegeben. Auch hier ist das erste Ende 17 der Klemmfeder 16 bevorzugt an der Führungsschiene 11 durch ein oder mehrere Schweißpunkte oder Lötpunkte dauerhaft befestigt oder durch eine Verschraubung oder Verklemmung lösbar an der Führungsschiene 11 gehalten. Auch wird durch den dachförmigen Verlauf des Klemmendes 18 gewährleistet, dass das Klemmende 18 unabhängig von der Schieberichtung des Substrats 13 in den zweiten die Schiebefläche freigebenden Zustand überführbar ist. Alternativ ist die Klemmfeder 16 derart angeordnet, dass sie von oben in den Schiebeweg des Substrats 13 vorsteht und dazu beispielsweise an der darüber liegenden Führungsschiene 11 befestigt ist.

Wie in Figur 2 gezeigt, sind den Führungsschienen 11 zumindest teilweise mehrere Klemmfedern 16 zugeordnet. Gemäß dem vorliegenden Ausführungsbeispiel von Figur 2 ist jedem Schubfach dabei eine Klemmfeder 16 an der Seitenwand 8 und zwei Klemmfedern 16 an der Seitenwand 9 zugeordnet.

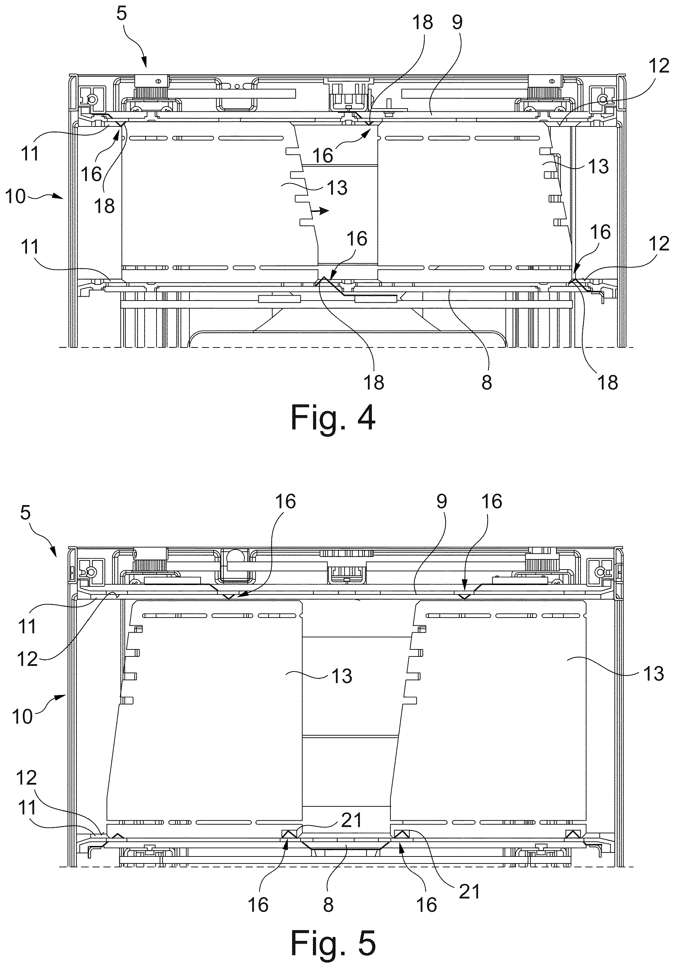

Figur 4 zeigt hierzu in einer vereinfachten Draufsicht auf ein Schubfach 10 das Substratmagazin 5. Die Seitenwände 8, 9 sind derart weit zueinander beabstandet angeordnet, dass die Substrate 13 randseitig auf den jeweils gegenüberliegenden Führungsschienen 11 des Schubfachs 10 aufliegen können. Beiden Führungsschienen 11 des Schubfachs 10 sind dabei jeweils zwei Klemmfedern 16 zugeordnet, die gemäß dem Ausführungsbeispiel von Figur 3A ausgebildet sind. Die Klemmfedern 16 an der Seitenwand 8 sind dabei versetzt zu den Klemmfedern 16 an der Seitenwand 9 in Schieberichtung der Substrate 13 derart angeordnet, dass zwischen einer Klemmfeder 16 an der Seitenwand 9 und an der Klemmfeder 16 an der Seitenwand 8 jeweils eines der Substrate 13 platzierbar ist. Der Versatz der Klemmfedern 16 an den Seitenwänden 8 und 9 zueinander ist somit derart groß gewählt, dass der in Schieberichtung gemessene Abstand größer ist als die Länge des jeweiligen Substrats 13. Dabei ist eine erste Klemmfeder 16 der Einschubseite des Schubfachs 10 und eine weitere Klemmfeder 16 der Ausschubseite des Schubfachs 10 zugeordnet, sodass ein versehentliches Lösen der Substrate 13 aus dem Magazin 5 heraus insgesamt verhindert ist. Die beiden verbleibenden Klemmfedern 16 befinden sich in einem mittleren Bereich des jeweiligen Schubfachs, und stellen sicher, dass die Substrate 13 nicht übereinander oder gegeneinander geschoben werden können.

Durch das Einschieben der Substrate 13 werden die Klemmenden 18 der Klemmfedern 16 zurückgedrängt, sodass die Substrate 13 jeweils in dem Zwischenraum zwischen zwei Klemmfedern, die in Längserstreckung hintereinander an unterschiedlichen Seitenwänden 8, 9 des Rahmens 7 angeordnet sind, zu liegen kommen. Dadurch ist jedem Substrat 13 ein Lagebereich durch jeweils zwei Klemmfedern 16 vorgegeben, in welchem sich das jeweilige Substrat 13 befindet und in welchem das jeweilige Substrat 13 sicher gehalten und an einem ungewollten Verschieben in dem Schubfach 10 gehindert ist. Mittels der Einrichtung 3 wird beim Entnehmen oder Zuführen eines der Substrate die Haltekraft der jeweiligen Klemmfeder 16 einfach überwunden. Bei einem Transport des insbesondere mobil ausgebildeten Substratmagazins 5, beispielsweise zu einer weiteren Fertigungslinie, in welcher die bestückten Substrate 13 eingesetzt werden sollen, werden die Substrate 13 jedoch durch die Klemmelemente 16 an der gewünschten Stelle gehalten.

Figur 5 zeigt ein weiteres Ausführungsbeispiel des Substratmagazins 5, das sich von dem vorhergehenden Ausführungsbeispiel dadurch unterscheidet, dass die hier vorhandenen Klemmfedern 16 mit den Seitenrandabschnitten des jeweiligen Substrats 13 zusammenwirken. Gemäß dem vorliegenden Ausführungsbeispiel sind an der Seitenwand 8 vier Klemmfedern 16 angeordnet und gemäß dem Ausführungsbeispiel von Figur 3A ausgebildet. Die mittleren beiden Klemmfedern 16 sind dabei einstückig an ihren Enden 17 miteinander verbunden, sodass die Klemmenden 18 letztendlich durch eine gemeinsame Klemmfeder 16 gebildet werden.

Auf der gegenüberliegenden Seite, an der Seitenwand 9 sind hingegen nur zwei Klemmfedern 16 angeordnet, die ebenfalls gemäß dem Ausführungsbeispiel von Figur 3A ausgebildet sind.

Im Unterschied zu dem vorhergehenden Ausführungsbeispiel sind die Klemmfedern beziehungsweise die Klemmenden 18 der Klemmfedern 16 derart angeordnet, dass ein Substrat 13 nicht zwischen zwei Klemmfedern in Schieberichtung gehalten ist, sondern dass die Klemmenden 18 mit dem Seitenrandabschnitt des jeweiligen Substrats 13 klemmend zusammenwirken. Durch die Federkraft und die dadurch entstehende Haftreibung zwischen den Klemmfedern 16 und dem jeweiligen Substrat 13 ist die Arretierung des jeweiligen Substrats 13 in dem Schubfach 10 ebenfalls gewährleistet.

Optional ist ein Substratmagazinsystem vorhanden, bei welchem die Substrate 13 auf das Substratmagazin 5 derart abgestimmt sind, dass sie seitliche Aussparungen 21 an zumindest einem Seitenrand aufweisen, in welchen das Klemmende 18 eines Federelements 16 jeweils eingreifen kann, wie in Figur 5 beispielhaft gezeigt. Dadurch ist das jeweilige Substrat 13 nicht nur kraftschlüssig, sondern auch formschlüssig in dem Schubfach 10 jeweils lösbar arretiert. Gemäß dem Ausführungsbeispiel von Figur 5 weisen die Substrate 13 an nur einem Randabschnitt die Aussparungen 21 auf, sodass auf der gegenüberliegenden Seite die dort vorhandene Klemmfeder 16 das Substrat 13 gegen die Seitenwand 8 drängt, wodurch die Arretierung weiter verbessert wird. In beiden Fällen ist die Arretierung durch ein Überwinden der jeweiligen Federkraft lösbar.

Selbstverständlich sind auch andere Anordnungen von Klemmfedern 16, insbesondere auch eine andere Anzahl von Klemmfedern 16 an der jeweiligen Führungsschiene 11 denkbar, sodass beispielsweise auch mehr als zwei Substrate 13 in Schieberichtung beabstandet zueinander in dem jeweiligen Schubfach 10 sicher gehalten werden können.

## Patentansprüche

1. Substratmagazin (5) für eine Substratbestückungsanlage (1), mit einem Rahmen (7), in welchem mehrere Schubfächer (10) zur Aufnahme von zumindest jeweils einem flächigen Substrat (13) übereinanderliegend angeordnet sind, wobei jedes Schubfach (10) durch zwei parallel und beabstandet zueinander auf derselben Höhe des Rahmens (7) angeordnete Führungsschienen (11) mit jeweils einer Schiebefläche (12), auf welcher ein Substrat (13) randseitig aufliegend verschiebbar ist, gebildet ist, wobei jedem Schubfach (10) zumindest ein elastisch verlagerbares Rastelement (14) zugeordnet ist, das sich in einem ersten, unbelasteten Zustand zumindest bereichsweise über die Schiebefläche (12) einer der Führungsschienen (11) des Schubfachs (10) erstreckt, und in einem zweiten elastisch verformten Zustand die Schiebefläche (12) freigibt, **dadurch gekennzeichnet, dass**
das Rastelement (14) als elastisch verformbare Klemmfeder (16) ausgebildet ist, die einendig an dem Rahmen (7) und/oder der Führungsschiene (11) befestigt und anderendig mit einem verlagerbaren Klemmende (18) der Schiebefläche (12) zugeordnet ist, wobei der Rahmen (7) und/oder die jeweilige Führungsschiene (11) für jede Klemmfeder (16) jeweils eine Aussparung (15) aufweisen, durch welche sich zumindest das Klemmende (18) der zugeordneten Klemmfeder (16) im ersten Zustand der Feder hindurch zu der Schiebefläche (12) erstreckt.

2. Substratmagazin nach Anspruch 1, **dadurch gekennzeichnet, dass** das Rastelement (14) einer Einschubseite des Schubfachs (10) zugeordnet ist.

3. Substratmagazin nach Anspruch 1, **dadurch gekennzeichnet, dass** das Rastelement (14) einer Ausschubseite des Schubfachs (10) zugeordnet ist.

4. Substratmagazin nach Anspruch 1, **dadurch gekennzeichnet, dass** das Rastelement (14) zwischen Einschubseite und Ausschubseite, insbesondere mittig, an der Führungsschiene (11) angeordnet ist.

5. Substratmagazin nach einem der vorhergehenden Ansprüche, **dadurch gekennzeichnet, dass** die Klemmfeder (16) zur Ausbildung des Klemmendes (18) einen V-förmigen Verlauf aufweist.

6. Substratmagazin nach einem der vorhergehenden Ansprüche, **dadurch gekennzeichnet, dass** die Klemmfeder (16) einen rechteckförmigen Querschnitt aufweist, der eine Höhe (H) und eine Breite (B) aufweist, wobei die Breite (B) im Vergleich zur Höhe (H) viel kleiner ist.

7. Substratmagazin nach einem der vorhergehenden Ansprüche, **dadurch gekennzeichnet, dass** die Klemmfeder (16) derart V-förmig in dem Klemmende (18) verläuft, dass das Klemmende (18) im Bereich der Schiebefläche (12) der zugeordneten Führungsschiene (11) eine Anlaufschräge (19) in jeder Schieberichtung entlang der Führungsschiene (11) aufweist.

8. Substratmagazin nach Anspruch 6, **dadurch gekennzeichnet, dass** die Klemmfeder (16) mit ihrer Höhe (H) senkrecht zur Ebene der Schiebefläche (12) ausgerichtet ist.

9. Substratmagazin nach Anspruch 6, **dadurch gekennzeichnet, dass** die Klemmfeder (16) mit ihrer Höhe (H) parallel zur Ebene der Schiebefläche (12) ausgerichtet ist.

10. Substratmagazin nach einem der vorhergehenden Ansprüche, **dadurch gekennzeichnet, dass** die jeweilige Klemmfeder (16) durch eine Verschraubung, Vernietung, Verrastung oder Klemmung an dem Rahmen (7) und/oder der Führungsschiene (11) befestigt ist.

11. Substratmagazin nach einem der vorhergehenden Ansprüche, **dadurch gekennzeichnet, dass** die jeweilige Klemmfeder (16) einendig mit dem Rahmen (7) verschweißt, verlötet und/oder verklebt ist.

12. Substratmagazin nach einem der vorhergehenden Ansprüche, **dadurch gekennzeichnet, dass** zumindest einer Führungsschiene (11) zwei Klemmfedern (16) zugeordnet ist, die in Schieberichtung der Führungsschiene (11) beabstandet zueinander angeordnet sind.

13. Substratmagazin nach einem der vorhergehenden Ansprüche, **dadurch gekennzeichnet, dass** jedem Schubfach (10) eine oder mehrere Klemmfedern (16) nur einer Führungsschiene (11) des Schubfachs (10) zugeordnet sind.

14. Substratmagazin nach einem der vorhergehenden Ansprüche, **dadurch gekennzeichnet, dass** jedem Schubfach (10) eine oder mehrere Klemmfedern (16) jeweils einer der Führungsschienen (11) des Schubfachs (10) zugeordnet sind.

15. Substratmagazinsystem mit einem Substratmagazin (5) nach einem der Ansprüche 1 bis 14 und mit einer Vielzahl von gleichförmigen Substraten (13), wobei ein horizontaler Abstand der Führungsschienen (11) auf einer Höhe (H) des Rahmens (7) zueinander derart gewählt ist, dass jedes der Substrate (13) beidseitig mit jeweils einem Randabschnitt auf den Führungsschienen (11) aufliegen kann.

16. Substratmagazinsystem nach Anspruch 15, **dadurch gekennzeichnet, dass** der Abstand von zwei einer Führungsschiene (11) zugeordneten Klemmfedern (16) größer als die Länge des Randabschnitts der Substrate (13) ist.

17. Substratmagazinsystem nach einem der Ansprüche 15 und 16, **dadurch gekennzeichnet, dass** jedes Substrat (13) zumindest eine seitliche Aussparung (21) in zumindest einem der Randabschnitte aufweist, die zur Aufnahme des Klemmendes (18) einer der Klemmfedern (16) ausgebildet ist.

18. Substratbestückungsanlage (1) zum Bestücken von Substraten (13) mit insbesondere elektrischen/elektronischen Bauteilen, mit zumindest einem Substratmagazin (5) nach einem der Ansprüche 1 bis 14 oder mit einem Substratmagazinsystem gemäß einem der Ansprüche 15 bis 17.

## Claims

1. Substrate magazine (5) for a substrate insertion system (1), comprising a frame (7) in which several drawers (10) for receiving at least one flat substrate (13) each are arranged one above the other, wherein each drawer (10) is formed by two guide rails (11), arranged in parallel and spaced apart from each other at the same height as that of the frame (7), each comprising a sliding surface (12) on which a substrate (13) lying on the edge is displaceable, wherein each drawer (10) is assigned at least one, elastically displaceable latching element (14) which, in a first, unloaded state, extends at least partially over the sliding surface (12) of one of the guide rails (11) of the drawer (10), and, in a second, elastically deformed state, releases the sliding surface (12),
**characterized in that** the latching element (14) is designed as an elastically deformable clamping spring (16) which is fastened at one end to the frame (7) and/or the guide rail (11), and is assigned at the other end to a displaceable clamping end (18) of the sliding surface (12), wherein the frame (7) and/or the respective guide rail (11) has, for each clamping spring (16), a respective cutout (15) through which at least the clamping end (18) of the assigned clamping spring (16) extends in the first state of the spring to the sliding surface (12).

2. Substrate magazine according to claim 1, **characterized in that** the latching element (14) is assigned to a push-in side of the drawer (10).

3. Substrate magazine according to claim 1, **characterized in that** the latching element (14) is assigned to a push-out side of the drawer (10).

4. Substrate magazine according to claim 1, **characterized in that** the latching element (14) is arranged, in particular, centrally, on the guide rail (11) between the push-in side and the push-out side.

5. Substrate magazine according to one of the preceding claims, **characterized in that** the clamping spring (16) has a V-shaped profile for forming the clamping end (18).

6. Substrate magazine according to one of the preceding claims, **characterized in that** the clamping spring (16) has a rectangular cross-section which has a height (H) and a width (B), wherein the width (B) is much smaller in comparison to the height (H).

7. Substrate magazine according to one of the preceding claims, **characterized in that** the clamping spring (16) extends in a V-shaped manner in the clamping end (18) in such a way that the clamping end (18) in the region of the sliding surface (12) of the assigned guide rail (11) has an initial bevel (19) in each sliding direction along the guide rail (11).

8. Substrate magazine according to claim 6, **characterized in that** the clamping spring (16) is aligned with its height (H) perpendicular to the plane of the sliding surface (12).

9. Substrate magazine according to claim 6, **characterized in that** the clamping spring (16) is aligned with its height (H) parallel to the plane of the sliding surface (12).

10. Substrate magazine according to one of the preceding claims, **characterized in that** the respective clamping spring (16) is fastened to the frame (7) and/or the guide rail (11) by screwing, riveting, latching, or clamping.

11. Substrate magazine according to one of the preceding claims, **characterized in that** the respective clamping spring (16) is welded, soldered, and/or glued at one end to the frame (7).

12. Substrate magazine according to one of the preceding claims, **characterized in that** two clamping springs (16) which are arranged at a distance from one another in the sliding direction of the guide rail (11) are assigned to at least one guide rail (11).

13. Substrate magazine according to one of the preceding claims, **characterized in that** one or more clamping springs (16) of only one guide rail (11) of the drawer (10) are assigned to each drawer (10).

14. Substrate magazine according to one of the preceding claims, **characterized in that** one or more clamping springs (16) in each case of one of the guide rails (11) of the drawer (10) are assigned to each drawer (10).

15. Substrate magazine system with a substrate magazine (5) according to one of claims 1 through 14 and comprising a plurality of uniform substrates (13), wherein a horizontal distance of the guide rails (11) from one another at a height (H) of the frame (7) is selected such that each of the substrates (13) can rest on both sides with a respective edge section on the guide rails (11).

16. Substrate magazine system according to claim 15, **characterized in that** the distance between two clamping springs (16) assigned to a guide rail (11) is greater than the length of the edge section of the substrates (13).

17. Substrate magazine system according to one of claims 15 and 16, **characterized in that** each substrate (13) has at least one lateral cutout (21) in at least one of the edge sections which is designed to receive the clamping end (18) of one of the clamping springs (16).

18. Substrate insertion system (1) for inserting substrates (13) with, in particular, electrical/electronic components, comprising at least one substrate magazine (5) according to one of claims 1 through 14 or a substrate magazine system according to one of claims 15 through 17.

## Revendications

1. Magasin de substrats (5) pour une installation de placement de substrats (1), avec un cadre (7) dans lequel plusieurs tiroirs (10) sont disposés les uns au-dessus des autres pour recevoir au moins respectivement un substrat plat (13), chaque tiroir (10) étant formé par deux rails de guidage (11) disposés parallèlement et à distance l'un de l'autre à la même hauteur du cadre (7) avec respectivement une surface de coulissement (12), sur laquelle un substrat (13) peut être coulissé en reposant sur le bord, au moins un élément d'encliquetage (14) déplaçable élastiquement étant associé à chaque tiroir (10), lequel s'étend, dans un premier état non sollicité, au moins par zones, sur la surface de coulissement (12) de l'un des rails de guidage (11) du tiroir (10), et, dans un deuxième état déformé élastiquement, libère la surface de coulissement (12), **caractérisé en ce que** l'élément d'encliquetage (14) est réalisé sous la forme d'un ressort de serrage (16) déformable élastiquement, qui est fixé à une extrémité au cadre (7) et/ou au rail de guidage (11) et est associé à l'autre extrémité, par une extrémité de serrage (18) déplaçable, à la surface de coulissement (12), le cadre (7) et/ou le rail de guidage (11) respectif présentant pour chaque ressort de serrage (16) respectivement un évidement (15) à travers lequel s'étend au moins l'extrémité de serrage (18) du ressort de serrage (16) associé dans le premier état du ressort vers la surface de coulissement (12).

2. Magasin de substrats selon la revendication 1, **caractérisé en ce que** l'élément d'encliquetage (14) est associé à un côté d'insertion du tiroir (10).

3. Magasin de substrats selon la revendication 1, **caractérisé en ce que** l'élément d'encliquetage (14) est associé à un côté d'extraction du tiroir (10).

4. Magasin de substrats selon la revendication 1, **caractérisé en ce que** l'élément d'encliquetage (14) est disposé entre le côté d'insertion et le côté d'extraction, en particulier au milieu, sur le rail de guidage (11).

5. Magasin de substrats selon l'une des revendications précédentes, **caractérisé en ce que** le ressort de serrage (16) présente un tracé en forme de V pour former l'extrémité de serrage (18).

6. Magasin de substrats selon l'une des revendications précédentes, **caractérisé en ce que** le ressort de serrage (16) présente une section transversale rectangulaire ayant une hauteur (H) et une largeur (B), la largeur (B) étant beaucoup plus petite par rapport à la hauteur (H).

7. Magasin de substrats selon l'une des revendications précédentes, **caractérisé en ce que** le ressort de serrage (16) s'étend en forme de V dans l'extrémité de serrage (18) de telle sorte que l'extrémité de serrage (18) présente, dans la zone de la surface de coulissement (12) du rail de guidage (11) associé, un chanfrein d'attaque (19) dans chaque direction de coulissement le long du rail de guidage (11).

8. Magasin de substrats selon la revendication 6, **caractérisé en ce que** le ressort de serrage (16) est orienté avec sa hauteur (H) perpendiculairement au plan de la surface de coulissement (12).

9. Magasin de substrats selon la revendication 6, **caractérisé en ce que** le ressort de serrage (16) est orienté avec sa hauteur (H) parallèle au plan de la surface de coulissement (12).

10. Magasin de substrats selon l'une des revendications précédentes, **caractérisé en ce que** le ressort de serrage (16) respectif est fixé au cadre (7) et/ou au rail de guidage (11) par vissage, rivetage, encliquetage ou serrage.

11. Magasin de substrats selon l'une des revendications précédentes, **caractérisé en ce que** le ressort de serrage (16) respectif est soudé, brasé et/ou collé d'un seul côté avec le cadre (7).

12. Magasin de substrats selon l'une des revendications précédentes, **caractérisé en ce qu'**au moins un rail de guidage (11) est associé à deux ressorts de serrage (16) qui sont disposés à distance l'un de l'autre dans la direction de coulissement du rail de guidage (11).

13. Magasin de substrats selon l'une des revendications précédentes, **caractérisé en ce qu'**à chaque tiroir (10) sont associés un ou plusieurs ressorts de serrage (16) d'un seul rail de guidage (11) du tiroir (10).

14. Magasin de substrats selon l'une des revendications précédentes, **caractérisé en ce qu'**à chaque tiroir (10) sont associés un ou plusieurs ressorts de serrage (16) correspondant chacun à l'un des rails de guidage (11) du tiroir (10).

15. Système de magasin de substrats avec un magasin de substrats (5) selon l'une des revendications 1 à 14 et avec une pluralité de substrats (13) de même forme, une distance horizontale des rails de guidage (11) les uns par rapport aux autres sur une hauteur (H) du cadre (7) étant choisie de telle sorte que chacun des substrats (13) puisse reposer des deux côtés avec respectivement une section de bord sur les rails de guidage (11).

16. Système de magasin de substrats selon la revendication 15, **caractérisé en ce que** la distance entre deux ressorts de serrage (16) associés à un rail de guidage (11) est supérieure à la longueur de la partie de bord des substrats (13).

17. Système de magasin de substrats selon l'une des revendications 15 et 16, **caractérisé en ce que** chaque substrat (13) comporte au moins un évidement latéral (21) dans au moins l'une des parties de bord, configuré pour recevoir l'extrémité de serrage (18) de l'un des ressorts de serrage (16).

18. Installation de placement de substrats (1) pour le placement de substrats (13) avec notamment des composants électriques/électroniques, avec au moins un magasin de substrats (5) selon l'une des revendications 1 à 14 ou avec un système de magasin de substrats selon l'une des revendications 15 à 17.
